# EUROPÄISCHE PATENTSCHRIFT

(11) **EP 2 006 866 B1**
(45) Veröffentlichungstag und Bekanntmachung des Hinweises auf die Patenterteilung: **22.02.2017**
(21) Anmeldenummer: 08104206.1
(22) Anmeldetag: 02.06.2008
(51) Int. Cl.: H05K 3/42, H01G 9/008, H01G 4/228, H01G 9/00, H05K 3/32

(54) **Elektronisches Bauelement mit einem mechanischen und/oder elektrisch leitfähigen Verbindungsmittel**
Electronic component with mechanical and/or electrically conductive connecting means
Composant électronique doté d'un moyen de raccordement mécanique et/ou conducteur électrique

(30) Priorität: 21.06.2007 DE 102007028520
(43) Veröffentlichungstag der Anmeldung: 24.12.2008
(73) Patentinhaber: ROBERT BOSCH GMBH, 70442 Stuttgart (DE)
(72) Erfinder: Danner, Reinhold, 72108 Rottenburg (DE); Lischeck, Andre, 71665, Vaihingen/Enz (DE); Schulz, Udo, 71665, Vaihingen/Enz (DE); Proepper, Thomas, 72762, Reutlingen (DE); Barth, Heinrich, 71229 Leonberg (DE)

(56) Entgegenhaltungen:
- DE-A1- 2 445 050
- JP-A- 11 219 854

## Beschreibung

Die Erfindung betrifft ein elektrisches/elektronisches Bauelement, das an einem Substrat befestigbar und/oder elektrisch anschließbar ist, mit mindestens einem mechanischen und/oder elektrisch leitfähigen Anschlussmittel.

Ferner betrifft die Erfindung eine elektrische/elektronische Baugruppe mit mindestens einem Substrat und mit mindestens einem elektrischen/elektronischen Bauelement.

### Stand der Technik

Elektrische/elektronische Bauelemente der eingangs genannten Art sind bekannt. So gibt es beispielsweise Elektrolyt-Kondensatoren, die zumindest zwei elektrisch leitende Drähte aufweisen, die aus einem Gehäuse des Kondensators herausführen und in beispielsweise Durchkontaktierungen einer als Substrat dienenden Leiterplatte gesteckt und damit verlötet sind. Die Drähte dienen hierbei für den Kondensator sowohl als elektrisch leitfähige Anschlussmittel als auch als mechanische Anschlussmittel beziehungsweise Haltemittel aufgrund der Verlötung. Bei derartigen Bauelementen ist eine Vielzahl von Prozessschritten zur Befestigung und Kontaktierung notwendig.

Die Offenlegungsschrift JP 11219854 A zeigt einen Elektrolytkondensator, der zwei Anschlusselemente aufweist, welche in Öffnungen eines Substrats eingeführt sind und rückseitig des Substrats verschraubt sind.

### Offenbarung der Erfindung

Die Erfindung sieht vor, dass das mechanische und/oder elektrisch leitfähige Anschlussmittel mindestens einen geprägten, insbesondere stanzgeprägten Kragen zum Einpressen in Vollmaterial des Substrats aufweist. Der Kragen ist vorteilhafterweise derart ausgebildet, dass er sich beim Einpressen in das Vollmaterial in dieses hineinschneidet. Das Bauelement wird somit über den Kragen an dem Substrat im Wesentlichen durch Klemmung befestigt beziehungsweise gehalten. Je nach Material des Kragens und/oder des Substrats ist auch ein zusätzliches Verlöten und/oder Verschweißen denkbar. Bei der Montage des Bauelements muss dieses mit dem Kragen lediglich auf das Substrat gepresst werden, um einen sicheren Halt zu gewährleisten. Dadurch wird die Anzahl der Prozessschritte verringert und die Montage wesentlich erleichtert. Vorteilhafterweise ist der Kragen ein aus einem Flachmaterial geprägter/stanzgeprägter Kragen.

Nach einer Weiterbildung der Erfindung weist der Kragen ein im Wesentlichen kreiszylinderförmigen Querschnitt auf. Natürlich sind auch andere Querschnittsformen des Kragens denkbar, wie zum Beispiel im Wesentlichen ovale und/oder eckige Querschnittsformen. Zweckmäßigerweise ist der Kragen mittig oder außermittig zu dem Bauelement angeordnet. Ist nur ein Kragen vorgesehen, so ist dieser bevorzugt mittig angeordnet, um ein einfaches Montieren beziehungsweise Einpressen zu ermöglichen. Ist der Kragen oder sind mehrere Kragen außermittig, insbesondere von außen frei zugänglich angeordnet, so ist ein Einpressen der Kragen möglich, ohne dass das Bauelement direkt belastet wird.

Erfindungsgemäß weist der Kragen an seinem freien Ende eine Hintergriffstruktur auf. Vorteilhafterweise wird die Hintergriffstruktur von mindestens einem Vorsprung gebildet, der bevorzugt im Wesentlichen senkrecht zu Einpressrichtung ausgerichtet ist. Die Hintergriffstruktur verhindert ein ungewolltes Lösen des Kragens beziehungsweise des Bauelements von dem Substrat. Bei dem Einpressvorgang wird die Hintergriffstruktur von dem Material des Substrats umschlossen, sodass ein sicherer Hintergriff gebildet ist. Die Hintergriffstruktur ist dabei vorteilhafterweise an der nach innen und/oder an der nach außen weisenden Seite des Kragens angeordnet.

Mit Vorteil ist vorgesehen, dass das Bauelement ein Gehäuse aufweist. In dem Gehäuse befinden sich zweckmäßigerweise die elektrischen/elektronischen Elemente, die die Funktion des Bauelements bestimmen.

Vorteilhafterweise ist das Anschlussmittel einstückig mit dem Gehäuse ausgebildet. Hierbei wird eine besonders einfache Montage möglich, da die zum Einpressen des Kragens notwendige Kraft direkt auf das Gehäuse und über das Gehäuse auf den damit einstückig ausgebildeten Kragen aufgebracht werden kann. Dies gewährleistet eine besonders sichere Anbindung des Bauelements an das Substrat, wobei das Einpressen allein über das Gehäuse erfolgt.

In einer vorteilhaften Weiterbildung ist der Kragen einstückig mit einer Auflageplatte ausgebildet, wobei Auflageplatte und Kragen zusammen das Anschlussmittel bilden, wobei die Auflageplatte im Wesentlichen senkrecht zu dem Kragen ausgerichtet ist. Beim Einpressen kommt die Auflageplatte beispielsweise auf dem Substrat zum Liegen und dient dabei als Anschlag für das Anschlussmittel. Darüber hinaus stabilisiert sie das Bauelement in seiner Position. Alternativ oder zusätzlich wirkt die Auflageplatte mit einem Bauteil des Bauelements, wie zum Beispiel mit einem Isolierelement des Bauelements zusammen, wobei lediglich der Kragen von dem Bauelement vorsteht.

Alternativ zu der beschriebenen einstückigen Ausbildung des Anschlussmittels mit dem Gehäuse ist das Anschlussmittel mittels der Auflageplatte in und/oder an dem Gehäuse gehalten. Besonders bevorzugt weist das Bauelement eine Kombination aus den oben genannten Ausbildungen des Anschlussmittels auf, also sowohl ein einstückig mit dem Gehäuse ausgebildetes Anschlussmittel, als auch ein mit einer in und/oder am Gehäuse angeordneten Auflageplatte einstückig ausgebildeten Kragen.

Vorteilhafterweise besteht das Anschlussmittel und/oder das Gehäuse des Bauelements aus einem elektrisch leitfähigen Material. Das Bauelement ist vorteilhafterweise derart ausgebildet, dass beim Aufsetzen des Anschlussmittels auf das Substrat die Auflageplatte vorteilhafterweise auf einer Leiterbahn zum Liegen kommt, sodass ein elektrischer Kontakt hergestellt wird. Alternativ oder zusätzlich weist der Kragen an seinem in das Vollmaterial einzupressenden Ende mindestens eine scharfe Kanten auf, die sich beim Einpressen in das Substrat in die Leiterbahn und/oder eine in dem Substrat ausgebildete Durchkontaktierung schneidet. Hierdurch wird ein besonders sicherer elektrischer Kontakt gewährleistet. In einer bevorzugten Ausführungsform wird ein erster elektrischer Kontakt des Bauelements von dem einstückig mit dem Gehäuse ausgebildeten Anschlussmittel beziehungsweise Kragen und ein zweiter elektrischer Kontakt von dem mit der Auflageplatte an dem Gehäuse gehaltenen Anschlussmittel gebildet.

Um zu verhindern, dass beim Einpressen in das Substrat, insbesondere des nicht einstückig mit dem Gehäuse ausgebildeten Kragens, der Kragen beziehungsweise das Anschlussmittel in das Bauelement hineingedrückt wird, wodurch die in dem Bauelement befindliche Elektrik/Elektronik beschädigt werden könnte, weist das Bauelement mindestens ein das Anschlussmittel beim Einpressen beaufschlagendes Stützelement auf. Das Stützelement ist derart in dem Bauelement beziehungsweise in dem Gehäuse des Bauelements angeordnet, dass eine auf das Gehäuse beaufschlagte Kraft über das Stützelement direkt auf das Anschlussmittel übertragen wird. Zum einen ist es somit möglich, das Bauelement selbst mit einer Kraft zu beaufschlagen, um den mechanischen und/oder elektrischen Kontakt herzustellen, und zum anderen wird das "Innenleben", also die in dem Gehäuse befindliche Elektrik/Elektronik, des Bauelements geschützt. Bevorzugt ist das Stützelement als eine Stützplatte ausgebildet, die zumindest bereichsweise auf der Auflageplatte des Anschlussmittels aufliegt und bevorzugt zumindest in Einpressrichtung mit dem Gehäuse des Bauelements zusammenwirkt.

In einer bevorzugten Ausführungsform weist dazu das Gehäuse mindestens einen das Stützelement beim Einpressen beaufschlagenden Vorsprung auf. Dieser ist vorteilhafterweise als eine sich über den gesamten Umfang des Gehäuses erstreckende Einschnürung ausgebildet. Beim Einpressen liegt das Stützelement zwischen dem Vorsprung und der Auflageplatte des Anschlussmittels, sodass über das Gehäuse des Bauelements die Einpresskraft auf das Stützelement und dann über die Auflageplatte auf den Kragen übertragen wird. Zweckmäßigerweise weist das Stützelement zumindest eine elektrisch leitfähige Leiterbahn auf, die bereichsweise auf der Auflageplatte aufliegt, sodass ein elektrischer Kontakt zu den in dem Gehäuse befindlichen elektrischen/elektronischen Elementen hergestellt wird. Im Übrigen besteht das Stützelement zweckmäßigerweise aus einem elektrisch nicht leitfähigen Material.

In einer bevorzugten Ausführungsform liegt die Auflageplatte des Anschlussmittels zwischen dem Stützelement und einem Isolierelement in dem Gehäuse des Bauelements ein, wobei der Kragen durch das Isolierelement hindurchragt. Das Isolierelement wird vorteilhafterweise von einer weiteren Einschnürung in dem Gehäuse gehalten, sodass die Einheit bestehend aus Stützelement, Anschlussmittel und Isolierelement, in dem Gehäuse durch die in Einpressrichtung gesehen hintereinander liegenden Vorsprünge gehalten wird.

Besonders bevorzugt weist der Kragen in Längsrichtung gesehen mehrere Schlitze auf, die ein Zusammendrücken des Kragens bei der Montage erlauben, sodass insbesondere das Isolierelement nicht beschädigt wird. Zweckmäßigerweise weist das Isolierelement eine im Wesentlichen kreiszylinderförmige Öffnung auf, in der der Kragen des Anschlussmittels einliegt.

In einer vorteilhaften Weiterbildung der Erfindung ist das Anschlussmittel als Bauelementhalter ausgebildet. Hierbei wird das Anschlussmittel durch Einpressen an dem Substrat befestigt und anschließend eine Elektrik-/Elektronikeinheit in das als Bauelementhalter ausgebildete Anschlussmittel eingesetzt, wobei der Bauelementhalter und die Elektrik-/Elektronikeinheit zusammen das Bauelement bilden. Dabei weist das Anschlussmittel eine Aufnahme zum zumindest teilweisen Aufnehmen der Elektronik-/Elektrikeinheit auf.

Schließlich ist vorgesehen, dass das Bauelement ein Elektrolyt-Kondensator ist. Wobei das Bauelement natürlich auch ein Trafo, eine Drossel, ein Relais oder ein Stecker sein kann.

Die erfindungsgemäße Baugruppe weist vorteilhafterweise mindestens ein Bauelement auf, dass wie obenstehend ausgebildet ist.

Vorteilhafterweise ist das Substrat als ein Kunststoffsubstrat ausgebildet, sodass der Kragen in das Substrat auf einfache Art und Weise eingepresst wird und dabei ein fester Halt zustande kommt.

Besonders bevorzugt ist das Substrat ein spritzgegossener Schaltungsträger mit mindestens einer Leiterbahn und/oder einer Durchkontaktierung. Dabei wird ein elektrischer Kontakt durch Einpressen des Kragens in die Leiterbahn beziehungsweise Durchkontaktierung hergestellt.

### Kurze Beschreibung der Zeichnungen

Im Folgenden soll die Erfindung anhand einiger Figuren näher erläutert werden. Dabei zeigen:
- Figur 1: ein erstes Ausführungsbeispiel eines vorteilhaften elektrischen/elektronischen Bauelements,
- Figur 2: ein zweites Ausführungsbeispiel des vorteilhaften Bauelements,
- Figur 3: ein drittes Ausführungsbeispiel des vorteilhaften Bauelements und
- Figur 4: ein viertes Ausführungsbeispiel des vorteilhaften Bauelements.

### Ausführungsform(en) der Erfindung

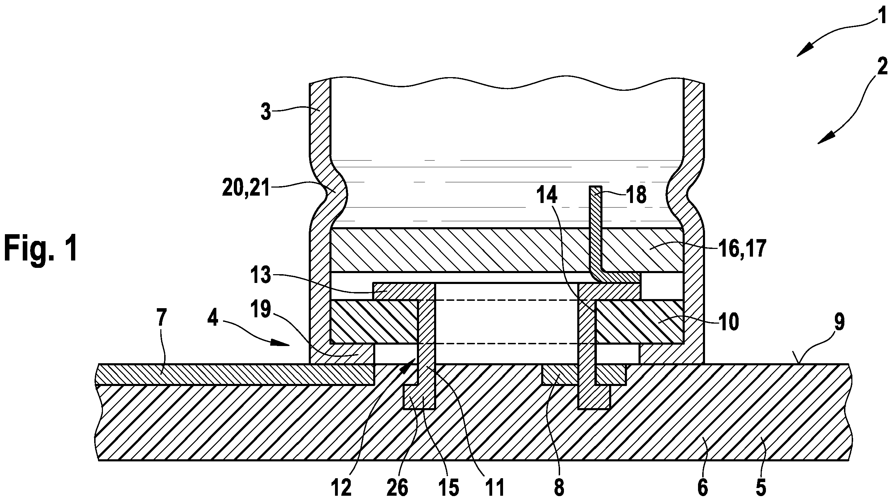

Die Figur 1 zeigt in einer Querschnittsdarstellung ein erstes Ausführungsbeispiel eines vorteilhaften elektrischen/elektronischen Bauelements 1. Das Bauelement 1 ist als ein Elektrolyt-Kondensator 2 ausgebildet und weist ein becherförmiges, im Wesentlichen kreiszylinderförmiges Gehäuse 3 auf. Das Gehäuse 3 liegt mit seinem Ende 4 auf einem Substrat 5 auf, welches als spritzgegossener Schaltungsträger 6 ausgebildet ist, wobei auf dem Substrat 5 beziehungsweise dem Schaltungsträger 6 zwei Leiterbahnen 7 und 8 angeordnet sind. Die Leiterbahnen 7 und 8 sind dabei in das Substrat 5 eingelassen, so dass sie bündig mit der Oberfläche 9 des Substrats 5 abschließen. In dem Gehäuse 3 des Bauelements 1 ist ein Isolierelement 10 angeordnet, welches von einem Kragen 11 eines Anschlussmittels 12 durchsetzt ist. Das Anschlussmittel 12 weist weiterhin eine Auflageplatte 13 auf, die einstückig mit dem Kragen 11 ausgebildet ist. Die Auflageplatte 13 ist im Wesentlichen senkrecht zur Längserstreckung des Kragens 11 ausgerichtet und liegt auf dem Isolierelement 10 auf, wobei der Kragen 11 eine Öffnung 14 des Isolierelements 10 durchsetzt. Der Kragen 11 ist bereichsweise in Vollmaterial des Substrats 5 eingepresst, wobei er die Leiterbahn 8 durchdringt. An seinem freien Ende 15 weist der Kragen eine sich über den gesamten Umfang des Kragens 11 erstreckende Hintergriffstruktur 26 auf, die an der Außenseite des Kragens 11 angeordnet ist.

Auf der dem Isolierelement 10 gegenüberliegenden Seite der Auflageplatte 13 ist ein Stützelement 16 angeordnet, das als Stützplatte 17 ausgebildet ist. Das Stützelement 16 ist von einer Kontaktfahne 18 durchdrungen, die mit der Auflageplatte 13 in elektrischen Kontakt steht und auf der in das Gehäuse 3 ragenden Seite mit einem hier nicht dargestellten elektrischen/elektronischen Element des Bauelements 1 elektrisch in Verbindung steht.

Das Gehäuse 3 weist an seinem Ende 4 einen nach innen ragenden Vorsprung 19 auf, auf dem das Isolierelement 10 auf der einen Seite aufliegt. Auf der anderen Seite liegt das Gehäuse 3 mit dem Vorsprung 19 auf der Leiterbahn 7 auf. Das Gehäuse 3 besteht aus einem elektrisch leitfähigen Material, so dass ein zwischen der Leiterbahn 7 und dem Gehäuse 3 ein elektrischer Kontakt zustande kommt. Beabstandet von dem Vorsprung 19 weist das Gehäuse 3 eine einen weiteren Vorsprung 20 bildende Einschnürung 21 auf, die sich über den gesamten Umfang des Gehäuses 3 erstreckt. Die Einschnürung 21 ist dabei derart angeordnet, dass zwischen ihr und dem Vorsprung 19 das Isolierelement 10, die Auflageplatte 13 sowie das Stützelement 16 gehalten sind.

Bei der Montage wird das Bauelement 3 an dem Substrat 5 befestigt und in einen elektrischen Kontakt mit den Leiterbahnen 8 und 7 gebracht, indem der Kragen 11 in das Vollmaterial des Substrats 5 an entsprechender Position auf dem Substrat 5 eingepresst wird. Der Kragen 11 schneidet sich dabei in das Substrat und durch die Leiterbahn 8, wobei die Hintergriffstruktur 26 ein Lösen des Anschlussmittels 12 beziehungsweise des Bauelements 1 von dem Substrat 5 verhindert. Der Kragen 11 wird so weit in das Substrat 5 eingepresst, bis das Gehäuse 3 auf der Leiterbahn 7 zum Liegen kommt. Die Einschnürung 21 beziehungsweise der Vorsprung 20 sorgen dafür, dass die Kraft von dem Gehäuse 3 auf die Stützplatte 16 und von der Stützplatte 16 über die Auflageplatte 13 auf den Kragen 11 übertragen wird. Durch die Einschnürung 21 wird verhindert, dass beim Einpressen des Kragens 11 dieser in das Innere des Gehäuses 3 gedrückt wird, wodurch die innen liegende Elektrik/Elektronik beschädigt werden könnte. Vorteilhafterweise weist der Kragen 11 an seinem Ende 15 Schneidkanten auf, die das Einpressen in das Substrat 5 erleichtern. Für einen sicheren Halt ist es vorteilhaft, dass das Substrat 5 einen möglichst geringen Anteil an Glasfasern enthält. In dem vorliegenden Ausführungsbeispiel sind sowohl das Gehäuse 3 als auch das Anschlussmittel 12 aus einem elektrisch leitfähigen Material gebildet.

Das vorteilhaft ausgebildete Bauelement 1 erlaubt ein einfaches Befestigen und Kontaktieren des Bauelements 1 beziehungsweise der auf dem Schaltungsträger 6 angeordneten Leiterbahnen 7 und 8. Dies erleichtert die Montage und verringert die Herstellungskosten. Vorteilhafterweise weist der Kragen 11 in Längsrichtung des Kragens 11 ausgerichtete Schlitze auf, die ein Zusammendrücken des Kragens 11 beim Einpressen erlauben.

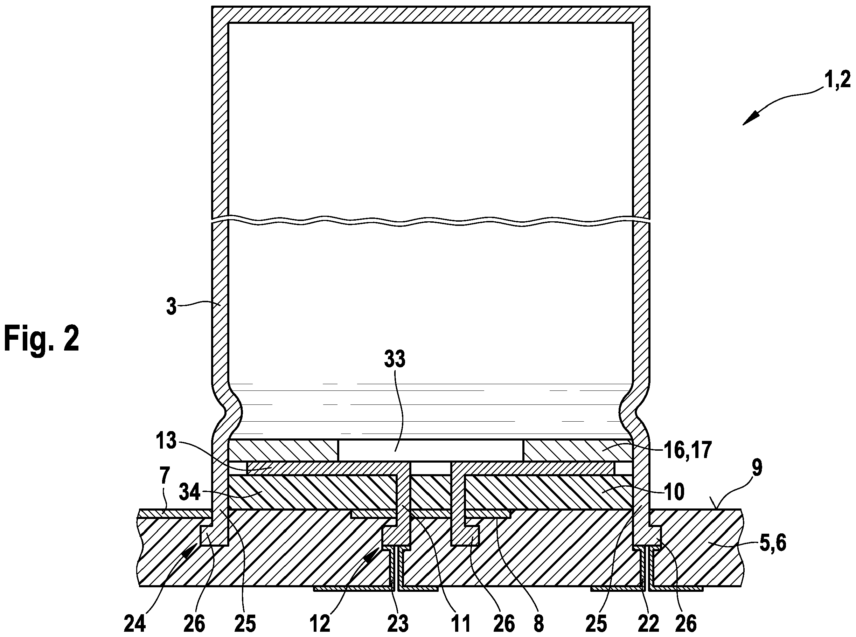

Die Figur 2 zeigt in einem zweiten Ausführungsbeispiel des als Kondensator 2 ausgebildeten Bauelements 1 aus der Figur 1 bereits bekannte Elemente, die in der Figur 2 mit den gleichen Bezugszeichen versehen sind. Im Wesentlichen entspricht das Bauelement 1 der Figur 2 dem Bauelement 1 der Figur 1, sodass hier lediglich auf die Unterschiede eingegangen werden soll. In dem Substrat 5 sind zwei Durchkontaktierungen 22 und 23 ausgebildet, wobei der Kragen 11 des Anschlussmittels 12 die Durchkontaktierung 23 schneidet, sodass zwischen der Durchkontaktierung 23 und dem Kragen 11 ein elektrischer Kontakt hergestellt wird. Darüber hinaus weist das Bauelement 1 ein weiteres Anschlussmittel 24 auf, das dem Anschlussmittel 12 im Wesentlichen entspricht. Wobei das Anschlussmittel 24 einen Kragen 25 aufweist, der einstückig mit dem Gehäuse 3 ausgebildet ist. Anstelle des Vorsprungs 19 ist hier der Kragen 25 vorgesehen, der ebenfalls in Vollmaterial des Substrats 5 eingepresst ist. Hierbei liegt das Isolierelement 10 direkt auf dem Substrat 5 auf. Wie der Kragen 11 weist auch der Kragen 25 an seinem freien Ende eine Hintergriffstruktur 26 auf, die die oben beschriebenen Vorteile mit sich bringt. Der Kragen 25 schneidet dabei die Leiterbahn 7 des Substrats 5 beziehungsweise des Schaltungsträgers 6. Darüber hinaus schneidet der Kragen 25 die Durchkontaktierung 22. Hierbei ist das Gehäuse 3 ebenfalls aus einem elektrisch leitenden Material hergestellt. Durch die vorteilhafte Ausbildung des in der Figur 2 dargestellten Bauelements 1 wird ein besonders fester mechanischer, sowie ein besonders sicherer elektrischer Kontakt gewährleistet.

Das in der Figur 2 dargestellte Stützelement 16 weist mittig eine Öffnung 33 auf, sodass die Auflageplatte 13 direkt mit Windungen des Kondensators in Kontakt treten kann. Dadurch wird der Aufbau des elektrischen/elektronischen Bauelements 1 vereinfacht. Das Isolierelement 10 wirkt vorteilhafterweise zusätzlich als Dichtungsmittel 34, um das "Innenleben" des Bauelements 1 vor äußeren Einwirkungen zu schützen.

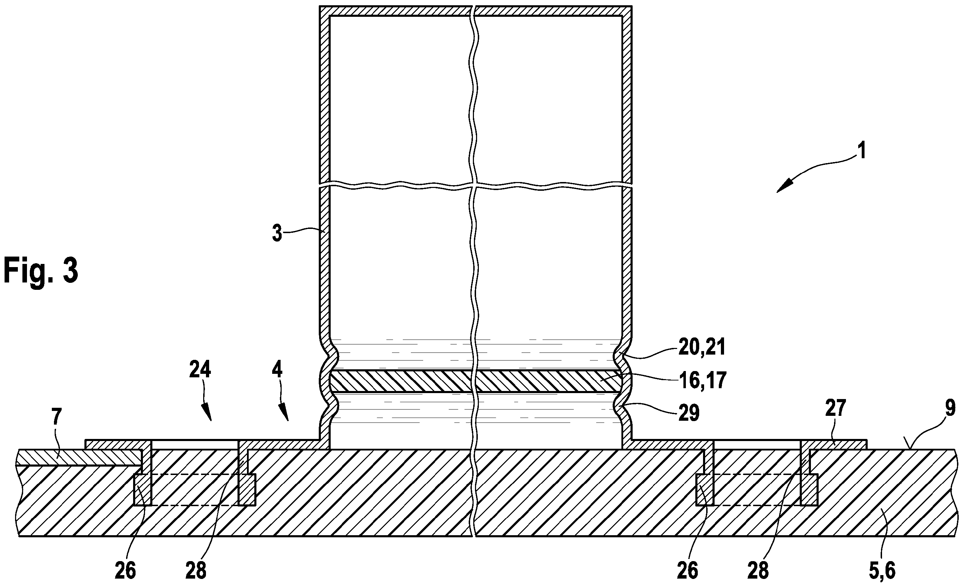

Die Figur 3 zeigt in einem weiteren Ausführungsbeispiel das Bauelement 1 in einer weiteren Schnittdarstellung. Im Unterschied zu dem vorherigen Ausführungsbeispiel weist das Anschlussmittel 24 an dem Ende 4 des Gehäuses 3 eine Auflageplatte 27 auf, die auf dem Substrat 5 aufliegt. In der Auflageplatte 27 sind mehrere Kragen 28, die den oben beschriebenen Kragen 25 und 11 entsprechen, ausgebildet. Im Gegensatz zu den oben beschriebenen, mittig angeordneten Kragen 11 und 25, sind die Kragen 28 außermittig zu dem wesentlichen Teil des Bauelements 1 angeordnet. Insbesondere sind sie derart angeordnet, dass sie von außen frei zugänglich sind. Der rechts eingezeichnete Kragen 28 dient dabei lediglich zur mechanischen Befestigung des Gehäuses 3 beziehungsweise des Bauelements 1 an dem Substrat 5, wohingegen der links eingezeichnete Kragen 28 die Leiterbahn 7 schneidet und somit als elektrisches Kontaktelement beziehungsweise Anschlussmittel wirkt. Der Übersichtlichkeit halber ist das Anschlussmittel 12 aus den vorhergehenden Figuren nicht dargestellt. Das Stützelement 16 wird hierbei zwischen der Einschnürung 21 sowie einer zweiten Einschnürung 29 gehalten.

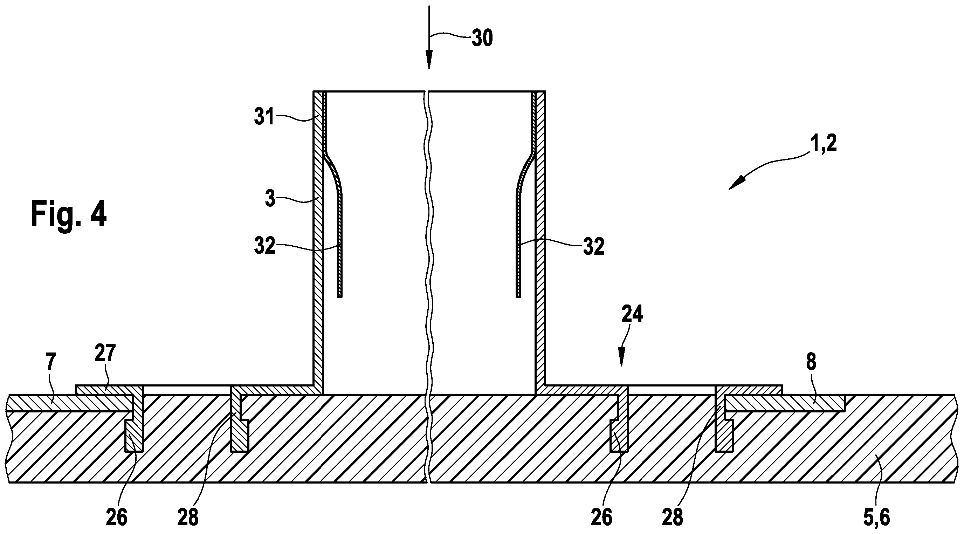

Die Figur 4 zeigt ein viertes Ausführungsbeispiel des vorteilhaften Bauelements 1, wobei das Ausführungsbeispiel der Figur 4 im Wesentlichen dem vorhergehenden Ausführungsbeispiel der Figur 3 gleicht, sodass hier nur auf Unterschiede eingegangen werden soll. In dem vorliegenden Ausführungsbeispiel ist das Gehäuse 3 nach oben hin offen ausgebildet, sodass in Richtung des Pfeils 30 eine Elektrik-/Elektronikeinheit in das Gehäuse 3 eingeschoben werden kann. An der Innenseite des Gehäuses 3 sind dabei Federelemente 32 angeordnet, die die Elektrik-/Elektronikeinheit in dem Gehäuse 3 festklemmen. Vorteilhafterweise ist das Gehäuse 3 zweiteilig ausgebildet, sodass, wie dargestellt, der linke Teil elektrisch mit der Leiterbahn 7 und der rechte Teil elektrisch mit der Leiterbahn 8 in Kontakt steht. Das Anschlussmittel 24 bildet hierbei somit einen Bauelementhalter 31, der zusammen mit der eingeschobenen, hier nicht dargestellten, Elektrik-/Elektronikeinheit das Bauelement 1 bildet.

Bei der Montage wird zunächst die Elektrik-/Elektronikeinheit in den Bauelementhalter 31 in Richtung des Pfeils 30 eingeführt und dann das gesamte Bauelement 1 auf das Substrat 5 mittels der Kragen 28 gepresst. Alternativ wird zunächst der Bauelementhalter 31 auf das Substrat 5 gepresst und anschließend die Elektrik-/Elektronikeinheit in den Bauelementhalter 31 geschoben.

Bei dem Einpress- beziehungsweise Fügevorgang ist es vorteilhaft, wenn das Fügewerkzeug das Gehäuse 3 umfänglich umfasst, und dann in die Leiterplatte presst. Dadurch wird ein Verformen des Gehäuses 3 im Wesentlichen vermieden. Vorteilhafterweise sind in dem Gehäuse 3 in Längsrichtung gesehen Wellen, Falze, Sicken oder ähnliches vorgesehen, um das Gehäuse 3 beim Einpressvorgang zusätzlich zu stabilisieren.

Das Kontaktieren von Kondensatoranschlüssen zu dem Bauelementhalter 3 kann über die Federelemente 32 und/oder durch Löten oder Schweißen erfolgen. Optional zu den Federelementen 32 ist auch ein nachträgliches Börteln oder Sicken denkbar, um die Kondensatorelemente beziehungsweise die Elektrik-/Elektronikeinheit zu fixieren.

Die in der Figuren 3 und 4 dargestellten Ausführungsformen haben den Vorteil, dass Fügekräfte beziehungsweise Einpresskräfte von dem die wesentlichen elektrischen/elektronischen Elemente des Bauelements 1 umschließenden Teils des Gehäuses 3 fernhält.

Das Substrat 5 ist derart ausgebildet, dass beim Einpressen beziehungsweise Einschneiden der Kragen 11, 25, 28 in das Vollmaterial des Substrats 5, wie in den Figuren 1 bis 4 dargestellt, das Substrat 5 zumindest bereichsweise lediglich elastisch verformt wird, so dass die Hintergriffstruktur 26 im Eingepressten/Eingeschnittenen Zustand im Wesentlichen allseitig von Material des Substrats 5 umgeben ist und einen sicheren Hintergriff bildet. Natürlich kann die in den Figuren 1 bis 4 dargestellte Hintergriffstruktur 26 auch kleiner oder größer ausgebildet sein und/oder einen anderen als den dargestellten, rechteckigen Querschnitt aufweisen. So kann die Hintergriffstruktur beispielsweise einen spitzen, ovalen, hakenförmigen oder kreis- oder teil kreisförmigen Querschnitt aufweisen. Wesentlich ist, dass nach dem Einpressen ein Hintergriff gewährleistet ist.

## Patentansprüche

1. Elektrisches/elektronisches Bauelement (1), das an einem Substrat (5) befestigbar und/oder elektrisch anschließbar ist, mit mindestens einem mechanischen und/oder elektrisch leitfähigen Anschlussmittel (12,24), **dadurch gekennzeichnet, dass** das Anschlussmittel (12,24) zur Befestigung an dem Substrat (5) durch Einpressen mindestens einen geprägten, insbesondere stanzgeprägten Kragen (11,25,28) aufweist, wobei der Kragen (11,25,28) an seinem freien, in das Substrat einzupressenden Ende, eine Hintergriffsstruktur (26) aufweist.

2. Elektrisches/elektronisches Bauelement nach Anspruch 1, **dadurch gekennzeichnet, dass** der Kragen (11,25,28) einen im Wesentlichen kreiszylinderförmigen Querschnitt aufweist.

3. Elektrisches/elektronisches Bauelement nach einem der vorhergehenden Ansprüche, **dadurch gekennzeichnet, dass**, das Bauelement (1) ein Gehäuse (3) aufweist.

4. Elektrisches/elektronisches Bauelement nach einem der vorhergehenden Ansprüche, **dadurch gekennzeichnet, dass** das Anschlussmittel (24) einstückig mit dem Gehäuse (3) ausgebildet ist.

5. Elektrisches/elektronisches Bauelement nach einem der vorhergehenden Ansprüche, **dadurch gekennzeichnet, dass** das Anschlussmittel (12,24) eine Auflageplatte (13,27) aufweist, die im Wesentlichen senkrecht zu dem Kragen (11, 28) ausgerichtet ist.

6. Elektrisches/elektronisches Bauelement nach einem der vorhergehenden Ansprüche, **dadurch gekennzeichnet, dass** das Anschlussmittel (12) mittels der Auflageplatte (13) in und/oder an dem Gehäuse (13) gehalten ist.

7. Elektrisches/elektronisches Bauelement nach einem der vorhergehenden Ansprüche, **dadurch gekennzeichnet, dass** das Bauelement (1) mindestens ein den Kragen (11) beim Einpressen beaufschlagendes Stützelement (16) aufweist.

8. Elektrisches/elektronisches Bauelement nach einem der vorhergehenden Ansprüche, **dadurch gekennzeichnet, dass** das Gehäuse (3) mindestens einen das Stützelement (16) beim Einpressen beaufschlagenden Vorsprung (20) aufweist.

9. Elektrisches/elektronisches Bauelement nach einem der vorhergehenden Ansprüche, **dadurch gekennzeichne**t, dass der Kragen (11,25,28) und/oder das Gehäuse (3) aus einem elektrisch leitfähigen Material bestehen.

10. Elektrisches/elektronisches Bauelement nach einem der vorhergehenden Ansprüche, **dadurch gekennzeichnet, dass** das Anschlussmittel (24) als Bauelementhalter (31) ausgebildet ist.

11. Elektrisches/elektronisches Bauelement nach einem der vorhergehenden Ansprüche, **dadurch gekennzeichnet, dass** das Bauelement (1) ein Elektrolyt-Kondensator (2) ist.

12. Elektrische/elektronische Baugruppe mit mindestens einem Substrat und mit mindestens einem Elektrischen/elektronischen Bauelement (1) nach einem oder mehreren der vorhergehenden Ansprüche.

13. Elektrische/elektronische Baugruppe nach Anspruch 13, **dadurch gekennzeichnet, dass** das Substrat (5) ein Kunststoffsubstrat ist.

14. Elektrische/elektronische Baugruppe, nach einem der vorhergehenden Ansprüche, **dadurch gekennzeichnet, dass** das Substrat (1) ein spritzgegossener Schaltungsträger (6) mit mindestens einer Leiterbahn (7,8) und/oder einer Durchkontaktierung (22,23) ist.

## Claims

1. Electrical/electronic component (1) which can be attached and/or can be electrically connected to a substrate (5), comprising at least one mechanical and/or electrically conductive connection means (12, 24), **characterized in that** the connection means (12, 24), for the purpose of being attached to the substrate (5) by pressing in, has at least one shaped, in particular stamped, collar (11, 25, 28), wherein the collar (11, 25, 28) has a undercut structure (26) at its free end which is to be pressed into the substrate.

2. Electrical/electronic component according to Claim 1, **characterized in that** the collar (11, 25, 28) has a substantially circular-cylindrical cross section.

3. Electrical/electronic component according to either of the preceding claims, **characterized in that** the component (1) has a housing (3).

4. Electrical/electronic component according to one of the preceding claims, **characterized in that** the connection means (24) is integrally formed with the housing (3).

5. Electrical/electronic component according to one of the preceding claims, **characterized in that** the connection means (12, 24) has a support plate (13, 27) which is oriented substantially perpendicularly to the collar (11, 28).

6. Electrical/electronic component according to one of the preceding claims, **characterized in that** the connection means (12) is held in and/or on the housing (13) by means of the support plate (13).

7. Electrical/electronic component according to one of the preceding claims, **characterized in that** the component (1) has at least one supporting element (16) which acts on the collar (11) during the pressing-in operation.

8. Electrical/electronic component according to one of the preceding claims, **characterized in that** the housing (3) has at least one projection (20) which acts on the supporting element (16) during the pressing-in operation.

9. Electrical/electronic component according to one of the preceding claims, **characterized in that** the collar (11, 25, 28) and/or the housing (3) are/is composed of an electrically conductive material.

10. Electrical/electronic component according to one of the preceding claims, **characterized in that** the connection means (24) is in the form of a component holder (31).

11. Electrical/electronic component according to one of the preceding claims, **characterized in that** the component (1) is an electrolytic capacitor (2).

12. Electrical/electronic assembly comprising at least one substrate and comprising at least one electrical/electronic component (1) according to one or more of the preceding claims.

13. Electrical/electronic assembly according to Claim 13, **characterized in that** the substrate (5) is a plastic substrate.

14. Electrical/electronic assembly according to one of the preceding claims, **characterized in that** the substrate (1) is an injection-moulded circuit carrier (6) comprising at least one conductor track (7, 8) and/or one plated-through hole (22, 23).

## Revendications

1. Composant électrique/électronique (1) qui peut être fixé et/ou raccordé électriquement à un substrat (5), comprenant au moins un moyen de raccordement (12, 24) mécanique et/ou électriquement conducteur, **caractérisé en ce que** le moyen de raccordement (12, 24) possède au moins un collet (11, 25, 28) estampé, notamment matricé, destiné à la fixation au substrat (5) par enfoncement, le collet (11, 25, 28) possédant une structure de préhension par l'arrière (26) sur son extrémité libre, à enfoncer dans le substrat.

2. Composant électrique/électronique selon la revendication 1, **caractérisé en ce que** le collet (11, 25, 28) présente une section transversale sensiblement de forme cylindrique circulaire.

3. Composant électrique/électronique selon l'une des revendications précédentes, **caractérisé en ce que** le composant (1) possède un boîtier (3).

4. Composant électrique/électronique selon l'une des revendications précédentes, **caractérisé en ce que** le moyen de raccordement (24) est réalisé d'un seul tenant avec le boîtier (3).

5. Composant électrique/électronique selon l'une des revendications précédentes, **caractérisé en ce que** le moyen de raccordement (24) possède une plaque d'appui (13, 27) qui est orientée sensiblement perpendiculairement au collet (11, 28).

6. Composant électrique/électronique selon l'une des revendications précédentes, **caractérisé en ce que** le moyen de raccordement (12) est maintenu dans et/ou sur le boîtier (13) au moyen de la plaque d'appui (13).

7. Composant électrique/électronique selon l'une des revendications précédentes, **caractérisé en ce que** le composant (1) possède au moins un élément support (16) qui charge le collet (11) lors de l'enfoncement.

8. Composant électrique/électronique selon l'une des revendications précédentes, **caractérisé en ce que** le boîtier (3) possède au moins une partie en saillie (20) qui charge l'élément support (16) lors de l'enfoncement.

9. Composant électrique/électronique selon l'une des revendications précédentes, **caractérisé en ce que** le collet (11, 25, 28) et/ou le boîtier (3) se composent d'un matériau électriquement conducteur.

10. Composant électrique/électronique selon l'une des revendications précédentes, **caractérisé en ce que** le moyen de raccordement (24) est réalisé sous la forme d'un support de composant (31).

11. Composant électrique/électronique selon l'une des revendications précédentes, **caractérisé en ce que** le composant (1) est un condensateur électrolytique (2).

12. Sous-ensemble électrique/électronique comprenant au moins un substrat et comprenant au moins un composant électrique/électronique (1) selon l'une ou plusieurs des revendications précédentes.

13. Sous-ensemble électrique/électronique selon la revendication 13, **caractérisé en ce que** le substrat (5) est un substrat en matière plastique.

14. Sous-ensemble électrique/électronique selon l'une des revendications précédentes, **caractérisé en ce que** le substrat (1) est un porte-circuit (6) moulé par injection comportant au moins une piste conductrice (7, 8) et/ou un contact traversant (22, 23).
